# EUROPÄISCHE PATENTSCHRIFT

(11) **EP 1 332 238 B1**
(45) Veröffentlichungstag und Bekanntmachung des Hinweises auf die Patenterteilung: **22.04.2009**
(21) Anmeldenummer: 01960161.6
(22) Anmeldetag: 09.08.2001
(51) Int. Cl.: C23C 14/02, C23C 14/04, H05K 3/04, B42D 15/10

(54) **METALLISIERTE FOLIE UND VERFAHREN ZU DEREN HERSTELLUNG SOWIE DEREN ANWENDUNG**
METALLIZED FILM, METHOD FOR THE PRODUCTION THEREOF, AND ITS USE
FILM METALLISE, PROCEDE PERMETTANT DE LE PRODUIRE ET UTILISATION

(30) Priorität: 09.10.2000 DE 20017392 U
(43) Veröffentlichungstag der Anmeldung: 06.08.2003
(60) Teilanmeldung: 08019431.9
(73) Patentinhaber: Hueck Folien Gesellschaft m.b.H., 4342 Baumgartenberg (AT)
(72) Erfinder: KASTNER, Friedrich, A-4710 Grieskirchen (AT); BERGSMANN, Martin, A-4060 Leonding (AT); HILLBURGER, Johann, 92712 Pirk (DE); EINSIEDLER, Ronald, A-4342 Baumgartenberg 78/4 (AT); TREUTLEIN, Roland, 92712 Pirk (DE)
(74) Vertreter: Hagemeier, Annette
(86) Internationale Anmeldenummer: PCT/DE2001/003040
(87) Internationale Veröffentlichungsnummer: WO 2002/031214

(56) Entgegenhaltungen:
- EP-A- 0 395 411
- EP-A- 0 475 145
- EP-A- 0 512 386
- EP-B- 0 944 480
- US-A- 4 354 911
- US-A- 4 402 998
- US-A- 4 582 564
- US-A- 4 622 106

## Beschreibung

Die Erfindung betrifft ein Verfahren zur Herstellung einer metallsierten Folien als Faden, Streifen oder Patch für Banknoten, Wertpapiere und Kreditkarten, als RF-Antenne für Transponder, Smart Cards, Smart Labels, Tags, als RF-Antenne in Diebstahletiketten, als Kontrolletiketten für die Qualitätssicherung.

Aus der WO 99/13157 sind beispielsweise Sicherheitsfolien für Wertpapiere und Verfahren zu ihrer Herstellung benannt. Eine solche Sicherheitsfolie zur Einlagerung oder Aufbringung in bzw. auf Wertpapiere besteht aus einer transluzenten Trägerfolie und einer darauf aufgebrachten metallischen Beschichtung, die metallfreie Bereiche aufweist, die insbesondere im Durchlicht klar zu erkennen sind. Zur Herstellung dieser metallisierten Folien wird die Trägerfolie bereitgestellt, dann die Trägerfolie mit einer Druckfarbe mit hohem Pigmentanteil bedruckt, dann die Druckfarbe zur Bildung eines porigen, erhabenen Farbauftrages getrocknet, auf der so bedruckten Trägerfolie dann eine dünne metallische Abdeckschicht gebildet, dann der Farbauftrag und die darüber liegende bzw. in den Farbauftrag eingedrungene Abdeckschicht durch Auswaschen mit einer Flüssigkeit, eventuell kombiniert mit mechanischer Einwirkung, entfernt, und schließlich die Trägerfolie getrocknet und ggf. zugeschnitten. Auf der Trägerfolie verbleibt somit in den ursprünglich nicht mit der Druckfarbe versehenen Bereichen die metallische Abdeckschicht, die laut der Veröffentlichung eine Dicke von 0,01 µm bis 1 µm haben kann.

Aus der EP 0 330 733 A1 ist ein Sicherheitselement in Form eines Fadens aus einer lichtdurchlässigen Kunststoffolie bekannt, das eine sich über das Element erstreckende opake Beschichtung mit Aussparungen in Form der einzubringenden Zeichen und Muster aufweist und bei dem zumindest in den zu den Aussparungen deckungsgleichen Bereichen farbgebende und/oder luminesziereride Substanzen enthalten sind, durch die sich die Zeichen und/oder Muster unter geeigneten Lichtbedingungen vom Sicherheitsdokument und von der opaken Beschichtung in farblich kontrastierender Form unterscheiden.

In der DE 36 87 250 T2 wird ein Verfahren zur Herstellung Metall-beschichteter dielektrischer Träger beschrieben, bei dem auf ein dimensionsbeständiges Polyimid-Substrat unter Vakuumbedingungen eine Schicht aus metallischen Chrom aufgedampft wird und anschließend auf diese Chromschicht galvanisch eine Kupferschicht aufgebracht wird. Um ein gewünschtes Muster auf den Kupferleiterbahnen zu erzeugen, wird die Kupferschicht geätzt und dann eine Schicht aus Gold oder Zinn oder einem Lötmittel auf diesen Leiterbahnen aufgebracht.

Die DE 36 10 379 A1 offenbart ein Verfahren zur Herstellung einer auf mindestens einer ihrer Oberflächen mit einer an vorgewählten Punkten unterbrochene Metallschicht vorgesehenen Folie. Bei diesem Verfahren wird die Metallschicht an den vorgewählten Stellen auf eine schlecht haftende Unterlage aufgebracht und den vorgewählten Stellen mechanisch abgetragen wird. Auf diese Weise kann die schlecht haftende Unterlage über die gesamte Oberfläche der Folie so verteilt werden, dass sich daraus das gewünschte Muster ergibt. Unabhängig von diesem Muster wird dann die gesamte Oberfläche metallisiert, so dass die Metallisierung relativ billig durchgeführt werden kann. Da die Metallschicht auf der schlecht haftenden Oberfläche nur lose aufgebracht ist, kann:sie relativ einfach mit mechanischen Mitteln von der Oberfläche gelöst werden.

So wird beispielsweise in der WO 99/19151 ein Sicherheitselement und ein Verfahren zu seiner Herstellung offenbart. Bei diesem Verfahren wird eine Trägerfolie mit einer geprägten Kunststoffschicht sowie einer anorganischen Hilfsschicht und einer vollflächigen Metallisierung versehen. Anschließend wird eine lösungsmittelresistente Druckfarbe in den Bereichen der Metallisierung aufgedruckt, die anschließend im Sicherheitselement verbleiben soll. Dieser Aufbau wird dann mit einem Lösungsmittel behandelt, mit dem die nicht abgedeckten Bereiche der Metallisierung sowie der Hilfsschicht entfernt werden, nicht jedoch die durch die Abdeckschicht geschützten Teile der Metallisierung und der Hilfsschicht.

Weitere metallisierte Folien und Verfahren zu deren Herstellung sind beispielsweise aus der EP 0 107 983 A1, EP 0 479 058 A1, EP 0 600 374 A1, DE 198 34 348 A1, DE 198 15 175 A1, DE 198 12 932 A1, DE 196 43 823 A1, DE 197 18 177 A1, DE 197 29 891 A1, DE 198 22 075 A1, DE 198 18 968 A1, US 4,242,378, US 4,685,997 und US 4,863,808 bekannt. Zur Vermeidung von bloßen Wiedergaben der jeweiligen Offenbarungsgehalte sind letztere hiermit durch Bezugnahme vollumfänglich in die vorliegenden Unterlagen aufgenommen, insbesondere hinsichtlich der Strukturen, Schichtdicken und Materialien der metallisierten Folien sowie der Verfahrensschritte zur Erzeugung von Mustern mit der metallischen Schicht.

Während es bei einigen Anwendungen von metallisierten Folien grundsätzlich wünschenswert sein kann, für bestimmte Anwendungen, wie beispielsweise Sicherheitsfolien für Wertpapiere, die metallische Schicht möglichst dünn zu halten, damit sie möglichst wenig aufträgt, erfordern andere Anwendungen dickere und dennoch sauber strukturierte oder geformte metallische Schichten mit feiner Musterung die mit den bekannten Verfahren nicht in befriedigender Weise hergestellt werden können, wie z.B. für Leiterbahnen oder Leiterplatten, insbesondere für Antennen, wie man sie beispielsweise in Handys findet.

Die vorliegende Erfindung hat zum Ziel, eine metallisierte Folie und ein Verfahren zu deren Herstellung zu schaffen, wobei die Folie strukturierte Schichten aus den verschiedensten Metallen, Metallverbindungen **oder** Legierungen auf einer oder beiden Seiten eines Trägermaterials aufweist. Weiterhin sollen diese strukturierten Schichten passergenau herstellbar sein, um damit beispielsweise Leiterbahnen oder dergleichen bauen zu können.

Die vorliegende Erfindung stellt ein Verfahren zur Herstellung einer metallisierten Folie gemäß den Ansprüchen 1 bis 11 bereit.

Erfindungsgemäß besteht eine solche metallisierte' Folie gemäß einer Variante der vorliegenden Erfindung aus einem Substrat oder einer Trägerfolie, auf dem oder auf der eine oder mehrere strukturierte dünne metallische Schicht(en) aufgebracht, im allgemeinen aufgedampft ist/sind, wobei das Substrat oder die Trägerfolie vor der Metallisierung durch Reinigung und Bekeimung vorbehandelt wird.

Auf der dünnen metallischen Schicht kann ggf. eine dickere metallische Verstärkungsschicht vorhanden sein, wobei die Verstärkungsschicht gemäß der vorliegenden Erfindung vorzugsweise durch chemischen oder galvanischen Materialaustrag hergestellt wird, um so eine Nachverstärkung der Musterschicht mit Material zu erreichen. Dies ist dann erforderlich, wenn Schichten von mehr als 1 µm erreicht werden sollen, da diese Schichtdicken nur unter erheblichem Aufwand durch vakuumbedampfen erreicht werden. Die Verstärkungsschicht weist jedoch dasselbe Muster wie die Musterschicht auf, wobei ein geringfügiges Hinausgehen der Verstärkungsschicht über die Musterschicht noch im Rahmen der Erfindung liegt.

Bei dem erfindungsgemäßen Verfahren zur Herstellung der metallisierten Folie wird zunächst das Trägermaterial gereinigt und bekeimt. Dieser Verfahrensschritt ist Voraussetzung für eine gute Haftung der partiell strukturiert oder vollflächig aufgebrachten Schicht zum Substrat. Auch im Fall einer Mehrschichtbedampfung ist dieser Schritt Voraussetzung, um die gute Haftung der Schichten untereinander zu gewährleisten. Hier bildet dieser Verfahrensschritt die Basis für Herstellung feinst strukturierte Schichten.

Wie bereits weiter oben ausgeführt, ist die Vorbehandlung des Substrats durch den Reinigungs- und Bekeimungsschritt Voraussetzung für eine gute Haftung. Um dies zu erreichen, insbesondere um die Haftung des Materials zu verbessern, kann das bedruckte Substrat mittels eines INLINE Plasma- oder Coronaprozesses vorbehandelt werden. Durch diese Vorbehandlung wird die Folienoberfläche von Tonungsresten der Druckfarben befreit und gleichzeitig aktiviert, da endständige polare Gruppen erzeugt werden. Darüber hinaus kann zeitgleich mit der Plasmavorbehandlung im Vakuum auch eine dünne Metall- oder Metalloxidschicht als Haftvermittler durch sputtern oder aufdampfen aufgebracht werden. Hierzu eignen sich insbesondere Cr, Al, Ag, Ni, Cu, Ti, TiO₂, SiOₓ, CrOₓ.

Die metallischen Schichten können im Rahmen des erfindungsgemäßen Verfahrens partiell oder vollflächig auf dem Substrat oder der Trägerfolie aufgebracht sein.

Bei einer anderen Verfahrensvariante der Erfindung wird auf die Trägerfolie zunächst eine vollflächige Metallisierung nach dem Reinigungs- und Bekeimungsschritt, beispielsweise mit Cu, insbesondere mit einer Schichtdicke von bis zu etwa 1,5 µm aufgebracht. Darauf wird dann zur Herstellung des letztlich gewünschten Musters ein Galvanoresist aufgedruckt, woran sich ggf. eine galvanische Nachverstärkung anschließt.

Eine weitere erfindungsgemäße metallisierte Folie besteht aus einem Substrat oder einer Trägerfolie, einer darauf aufgebrachten metallischen Musterschicht, die durch Ätzen hergestellt wurde. Bei dem entsprechenden Verfahren werden auf eine vollflächige metallische Schicht, die z.B. Cu enthält, entsprechend dem gewünschten Muster ein Ätzresist aufgebracht und danach ein Ätzvorgang durchgeführt, so dass die Musterschicht in der gewünschten Formgebung und Dicke übrig bleibt und so die metallischen Schichtaufbauten hergestellt werden.

Außerdem ist es möglich mit dem erfindungsgemäßen Verfahren eine metallisierte Folie mit einem Mehrschichtaufbau (Multilayer) bereitzustellen. Dabei kann der Mehrschichtaufbau durch vollflächig übereinander aufgebrachte Schichten verschiedener Materialien sein. Durch die Kombination von Schichten mit unterschiedlichen physikalischen Eigenschaften, z. B. unterschiedlicher Leitfähigkeit, Magnetisierbarkeit, Absorptionsverhalten, Schirmung, Barriere, weitere optische Effekte in einem Produkt sind die Multilayer-Produkte vielfältig einsetzbar.

Anderseits können durch mehrfache Anwendung des Verfahrens zur Schichtstrukturierung sowie passergenauem Druck im Längs- und Seitenregister zur vorherigen Strukturierung funktionelle Mehrschichtsysteme aufgebaut werden, insbesondere können zwischen den einzelnen Schichten auch partielle oder vollflächige Lack- und Folienschichten aufgebracht sein. Prinzipiell sind durch das erfindungsgemäße Verfahren beliebig viele Schichten realisierbar. Je nach weiterer Anwendung kann das Produkt mit einem siegelfähigen Kleber (Heiß- oder Kaltsiegelkleber) ausgestattet sein und ähnlich einer. Heißprägefolie auf verschiedene Trägersubstrate appliziert sein. Die Trägerfolie kann dann nach der Anwendung entfernt werden oder verbleibt am Produkt. Im letzteren Fall kann die Trägerfolienrückseite noch eine zusätzliche Ausrüstung, wie kratzfeste oder antistatische Eigenschaften erhalten. Durch weiterführende Prozessschritte können die Multilayer-Systeme veredelt werden, hier bietet sich insbesondere eine weiterführende Kaschierung an.

Auch bei der Herstellung der metallisierten Folie mit einem Mehrschichtaufbau ist eine wesentliche Voraussetzung zur Verbesserung der Haftung der aufgedampften Metallschichten untereinander der Schritt der Plasmavorbehandlung unter gleichzeitiger Sputterbekeimung mit ebenfalls dem gleichen Metall in jedem Aufdampfschritt der Mehrschichtbedampfung gleichen Materials. Bei der Mehrschichtbedampfung mit unterschiedlichen Materialien wird die bereits bestehende Schicht analog vorbehandelt.

Nachfolgend werden Ausführungsformen der Erfindung anhand der beigefügten Zeichnungen erläutert. Es zeigen:
- Fig. 1: eine schematische Darstellung eines Schnitts durch einen Schichtaufbau einer partiell bedampften metallischen Folie im Herstellungsstadium;
- Fig. 2: eine schematische Darstellung eines Schnittes durch das fertige Endprodukt einer partiell bedampften metallischen Folie;
- Fig. 3: eine schematische Darstellung eines Schnittes durch das fertige Endprodukt eines vollflächigen Mehrschichtenaufbaus;
- Fig. 4: eine schematische Darstellung eines Schnittes durch das fertige Endprodukt eines partiell bedampften Mehrschichtenaufbaus.

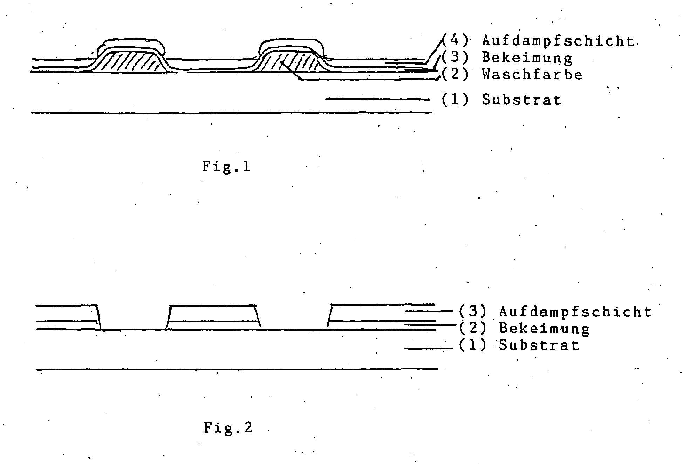

Wie in Fig. 1 gezeigt, wird für die Herstellung einer partiell bedampften metallischen Folie zunächst ein Substrat oder eine Trägerfolie (1) bereitgestellt. Auf dieses Substrat wird eine Lösliche Farbe (Waschfarbe) (2) aufgetragen. Dieses bedruckte Substrat oder diese bedruckte Folie wird durch einen Reinigungs- und Bekeimungsvorgang vorbehandelt, wodurch eine Bekeimungsschicht (3) zur besseren Haftung der metallischen Schicht erzeugt wird, dann wird die metallische Schicht (4) aufgedampft.

Fig. 2 zeigt die partiell bedampfte metallische Folie als Endprodukt, bei dem die Lösliche Farbe (Waschfarbe) durch einen mechanischen Waschvorgang entfernt wurde und die zeigt, dass nach Lösen der löslichen Farbe (Waschfarbe) die aufgedampfte metallische Schicht (3) samt Bekeimung (2) partiell auf dem Substrat (1) gebildet wurde.

### Bei in Fig. 1 und Fig. 2 beschriebenen Ausführungsformen handelt es sich um Referenzbeispiele.

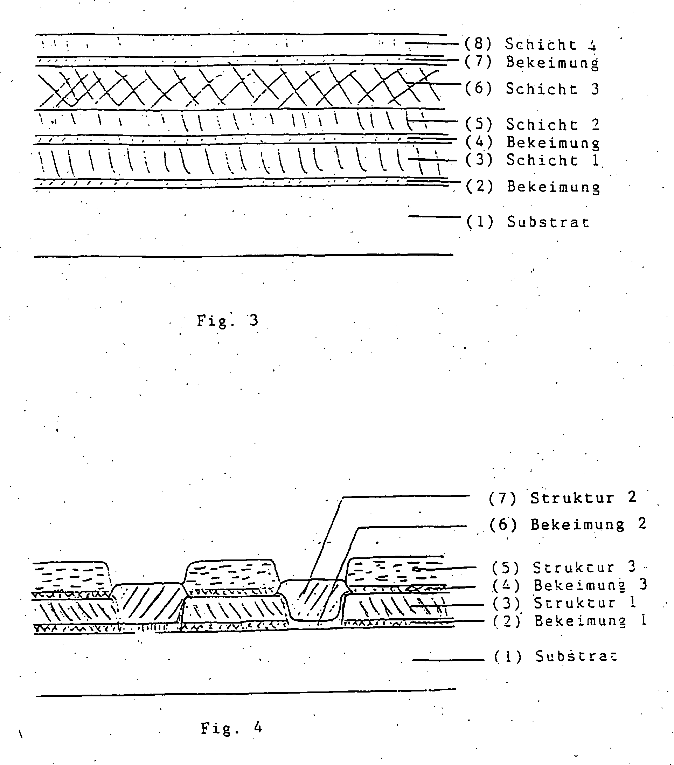

Wie in Fig. 3 gezeigt, wird für Herstellung einer metallischen Folie mit einem Mehrschichtenaufbau ein Substrat (1) verwendet, das einer Bekeimungsschicht (2) versehen ist, die durch den oben beschriebenen Plasmareinigungsprozeß mit gleichzeitiger Bekeimung erzeugt wurde. Auf diese Bekeimungsschicht (2) wird dann die Metallschicht (3) aufgedampft. Die Schritte der Bekeimung und der Metallbedampfung werden so oft wiederholt, wie es für das fertige Endprodukt gewünscht ist. Dabei können alle Bekeimungsschichten aus dem gleichen Material oder aus unterschiedlichen Materialien sein und genauso können die Metallschichten jeweils aus dem gleichen oder unterschiedlichen Materialien sein. Außerdem kann eine oder mehrere Schichten dieses Aufbaus auch aus nichtmetallischen Substanzen, die oben erwähnt sind, bestehen. In dem hier gezeigten Beispiel wurden vier Bekeimungs- und Aufdampfschritte durchgeführt.

Je nach Anwendung kann dieser vollflächige Aufbau aus Fig. 3 bereits dem Endprodukt entsprechen, wie es z.B. für optische Beschichtungen für Reflexionsschichten verwendet wird, wo durch den Schichtaufbau und die Anzahl der Schichten die Wellenlängenbereiche für Reflexion einstellbar sind oder durch Aufbringen eines Ätzresists und ätzen strukturiert werden. Das Endprodukt würde dem in Fig. 2 gezeigten, allerdings mit mehreren übereinander liegenden Bekeiumungs- und Aufdampfschichten entsprechen.

Fig. 4 zeigt eine andere Ausführungsform des Mehrschichtenaufbaus, bei der ein Substrat (1) bekeimt wird und die Struktur 1 (3), wie auch schon in Fig. 2 beschrieben, erzeugt wird. Nach Strukturierung der Schicht (3) zur Struktur 1 wird lösliche Farbe (Waschfarbe) passergenau in die beim ersten Verfahrenszyklus unbedruckten aufgedruckt, danach wird wieder bekeimt (6) (Bekeimung 2) und beschichtet (7) und die Schicht zur Struktur 2 strukturiert (7). Dann wird erneut die Struktur 1 mit einer löslichen Farbe versehen, bekeimt (4) und strukturiert (5), wobei die Struktur 3 hergestellt wird. Dieser Vorgang kann mehrmals, im Prinzip beliebig oft, wiederholt werden. Dadurch wird es z.B. möglich, dass zwei Strukturen aus unterschiedlichen Materialien in derselben Ebene definiert herstellt werden können, wo sich die Struktur 2 (6) genau in den Bereichen befindet, die bei der Erzeugung von Struktur 1 (3) entfernt wurden.

Die metallisierten Folien werden für daraus hergestellte RF-(Radiofrequenz) Antennen insbesondere für Transponder verwendet. Sie eignen sich insbesondere als Smart Cards, die als kontaktlose Systeme, z. B. für Zutrittsberechtigungen im öffentlichen Personennahverkehr, in Skigebieten als Skipässe, oder für Sicherheitsschleusen, Verwendung finden, die aber auch für Kreditkarten oder Kundenkarten, sowie im Flugverkehr als bspw. "Miles & More®"-Karten eingesetzt werden können. Weiterhin können sie als Smart Labels als kontaktlos lesbare und beschreibbare Alternative zum Barcode beispielsweise für Paketdienste, Bibliotheken und im Einzelhandel verwendet werden. Auch ist ein Einsatz als Tags möglich, wie sie in Flughäfen als Kofferanhänger verwendet werden.
Als RF-Antennen können sie auch als Diebstahletiketten eingesetzt werden, wobei eine RF-Antenne mit einem Kondensator (gedruckt oder bestückt) kombiniert wird, so dass ein Signal beim Verlassen eines Geschäfts ausgelöst wird, wenn das System nicht deaktiviert wurde.

Außerdem ist ein Einsatz als Kontrolletikett für Qualitätskontrollen denkbar, wobei die RF-Antenne ebenfalls mit einem Kondensator (gedruckt oder bestückt) kombiniert wird. So kann bei der Endkontrolle bspw. von Fahrzeugen mittels verschiedener Frequenzen ein akustisches Signal abgefragt werden, ob bestimmte "nichtsichtbare" Bauteile im Fahrzeug eingebaut wurden, wobei die Etiketten auf den jeweiligen Bauteilen nur auf eine bestimmte Frequenz reagieren.

Darüber hinaus können die metallisierten Folien in Leiterplatten verwendet werden, die nur Signalströme zu leiten haben und mit dem erfindungsgemäßen Herstellungsverfahren kostengünstig, etwa 90 % billiger als mit den bekannten Verfahren, hergestellt werden können. Dies sind insbesondere Leiterplatten, aus denen Sensorelemente für verschiedene Anwendungsbereiche, wie zum Beispiel Fernbedienungen gebaut werden. Dabei können die Sensorelemente nach den physikalischen Prinzipien kapazitiv, induktiv, leitfähig, über Wärme oder Druck arbeiten.

Außerdem sind die metallisierten Folien als Faden, Streifen oder Patch für Banknoten, Wertpapiere und Kreditkarten verwendbar.

Vor der Metallisierungwird der INLINE-Plasmaprozeß eingesetzt. Durch energiereicher, z.B.Argon oder Argon-/Sauerstoff-Plasma wird eine Farbtonung vor der Metallisierung entfernt, also sozusagen eine Plasma-Reinigung der bedruckten Trägerfolie durchgeführt. Als weiterer Vorteil aktiviert das Plasma zusätzlich die Folienoberfläche der Trägerfolie und schafft polare endständige Gruppen an dieser Oberfläche, was zusätzlich zu einer Verbesserung der Metallhaftung führt. Als noch weiterer Vorteil findet bei der Plasma-Vorbehandlung auch eine Bekeimung der Folienoberfläche der Trägerfolie mit Targetatomen, wie beispielsweise Ti, Cu, Al oder Cr, statt, was ebenfalls zu einer Haftungsverbesserung des Metalls an nicht bedruckten Stellen der Folienoberfläche der Trägerfolie führt.

Bei der Trägerfolie handelt es sich vorzugsweise um eine flexible Kunststoff-Folie, ausgewählt aus der Gruppe, bestehend aus PI, PPS, PEEK, PEK, PK, PEI, PSU, PESU, PAEK, LCP, TPU, PEN, PBT, PET (OPET, PETG, APET), PA (PA 6, .PA 6.6, PA 4.6, PA 6/66, PA 12, PA 6.12), PC, COC, POM, ABS, PVC, PP, PE, ETFE, PTFE, die eine Dicke von 6 µm bis 700 µm aufweisen Bei der Trägersubstanz handelt es sich um Papier mit einer Dicke von 30 g/m² bis 200 g/m² oder Aluminum-Folien mit einer Dicke von 8 µm bis 100 µm sowie Spinnvliese, Stäpelfaservliese und SMS-Vliese, die aus folgenden Polymeren PP, PET, PA und PPS hergestellt wurden, sowie Viskosevliese, die alle eine Dicke von 20 g/m² bis 500 g/m² aufweise. Die oben genannten Materialien sind insbesondere für eine vollflächige Bedampfung geeignet.
Außerdem können die vorstehend genannten Folien noch zusätzlich strukturiert sein (3D). Diese Strukturierung kann durch bürsten, schleifen und/oder thermisches prägen in die Folien sowie durch eine Prägung in einen noch nicht ausgehärteten Lack, der auf die Folie aufgetragen wurde, mittels thermischer, ionischer oder UV-Härtung (radikalisch oder kationisch) ausgeführt werden.
Für die Herstellung der Mehrschichtensysteme können die einzelnen Trägermaterialien aus unterschiedlichen Lagen, wie unterschiedlichen Polymerfolien, wie oben genannt, aber auch aus der Kombination Folien/Papier oder Folien/Vliese und dergleiche Kombinationen aufgebaut sein. Ebenso kann sich eine bereits bedampfte Schicht oder eine Metallfolie im Trägermaterial befinden.
Für die partielle metallische Bedampfung eignen sich als Trägerfolien insbesondere Polymere ausgewählt aus der Gruppe, bestehend aus PI, PPS; PEEK, PEK, PK, PEI, PSU, PESU, PAEK, LCP, TPU, PEN, PBT, PET (OPET, PETG, APET), PA (PA 6, PA 6.6, PA 4.6, PA 6/66, PA 12, PA 6.12), PC, COC, POM, ABS, PVC, PP, PE, ETFE, PTFE, die eine Dicke von 6 µm bis 700 µm aufweisen.
Auch hier können für die Herstellung der Mehrschichtensysteme die einzelnen Trägermaterialien aus unterschiedlichen Lagen, wie unterschiedlichen Polymerfolien, wie oben genannt, aber auch aus der Kombination Folien/Papier oder Folien/Vliese und dergleichen Kombinationen aufgebaut sein. Ebenso kann sich eine bereits bedampfte Schicht oder eine Metallfolie im Trägermaterial befinden. Die partiell bedampfte Schicht befindet sich dabei vorzugsweise auf der glatten Polymerseite.

Die Musterschicht und ggf. die Verstärkungsschicht bilden vorzugsweise Muster, wie z.B. Bahnen, aus Metall, wobei diese entsprechend einer Variante der Erfindung zumindest im wesentlichen aus Cu bestehen.

Die Trägerfolie weist eine Dicke von 6 µm bis 700 µm, vorzugsweise von 12 µm bis 100 µm, insbesondere bevorzugt von 15 µm bis 50 µm.

Bei einer Musterschicht, die nachträglich mit einer Verstärkungsschicht versehen wird, hat die Musterschicht bevorzugt eine Dicke von wenigstens ungefähr 0,05 µm bis 1 µm, vorzugsweise 0,2 µm, insbesondere 0,4 µm.

Die Musterschicht ggf. zusammen mit der Verstärkungsschicht hat/haben vorzugsweise ggf. zusammen eine Dicke von 1 µm bis zu etwa 50 µm, vorzugsweise um 2 µm bis 35 µm, insbesondere 3 µm bis 15 µm.

Vorzugsweise Dicken der reinen Verstärkungsschicht in Abhängigkeit vom jeweiligen Herstellungsverfahren sind bei der partiellen Metallisierung der Trägerfolie und Nachverstärkung durch chemische oder galvanische Prozesse etwa 1 µm bis 25 µm, insbesondere 1 µm bis 5 µm und speziell 2 µm bis 3 µm, und bei der vollflächigen Grundbeschichtung mit metallischen Material (insbesondere ca. 0,2 µm bis 0,4 µm Schichtdicke) mit. Nachverstärkung und Differenzätzen ca. 2 µm bis 25 µm, wobei ein Ätzresist mit einer Dicke von z.B. etwa 2 µ bis 3 µm verwendet wird.

Die Musterschicht ggf. zusammen mit der Verstärkungsschicht weist entsprechend bevorzugter Ausgestaltungen der Erfindung eine Struktur auf, die von Metallisierung freie Bereiche mit einer Breite von weniger als ca. 150 µm enthält. Dies bedeutet z.B., dass die Musterschicht ggf. zusammen mit der Verstärkungsschicht, wenn sie Leiterbahnen bildet/bilden, diese Leiterbahnen einen Abstand von weniger als ca. 150 µm aufweisen.

Die strukturierte(n) Schicht(en) besteht(en) aus Metallen, bevorzugt aus Cu, Al, Fe, Ag, Au, Ni, Cr, Metallverbindungen, bevorzugt TiO₂, CrOx, Zn, ITO, FTO, ATO, ZnO, Al₂O₃, SiOₓ, Legierungen, bevorzugt Cu-Al, Cu-Zn sowie Isolatoren, wie organischen Substanzen und deren Verbindungen (Farb- und Lacksysteme), z.B. Epoxy-, Polyester-, Kolophonium-, Acrylat-, Alkyd-, Melamin-, PVA-, PVC-, Isocyanat-, Urethansysteme, die sowohl thermisch als auch UV-härtend sein können.

Das bevorzugte Verfahren wird wie folgt durchgeführt (einzeln oder kombiniert):
- Reinigen und Bekeimen der Trägerfolie oder Trägersubstanz durch Plasmavorbehandlung im Vakuum,
- vollflächige Metallisierung einer Trägerfolie oder einer Trägersubstanz, beispielsweise mit Cu,
- Veredelung einer z.B. mit Cu metallisierten Folie durch Bedrucken mit einem Ätzresist,
- Tief- oder Flexodruck einer Silberleitpaste auf eine Kunststoff-Folie,
- Tief- oder Flexodruck eines leitfähigen Startlacks für die Galvanik,
- Tief- oder Flexodruck eines Ätz- oder Galvanoresists auf eine insbesondere mit Cu metallisierte vorzugsweise Kunststoff-Folie,
- Tief- oder Flexodruck eines Primers als Haftvermittler für Metallisierung auf definierten Bereichen der Folie (Strukturierung durch stärker haftende Bereiche),
- ein rückseitiger Isolationsdruck, ein Silberdruck und/oder eine Kaschierung sind denkbar und unter Umständen wünschenswert

Damit lassen sich metallische Schichten oder Schichtkombinationen beispielsweise aus Cu erzeugen, deren Dicke deutlich über 0,2 µm und deren Pitchabstände unter 0,5 mm liegen.

Wesentliche Vorteile der einzelnen Varianten und Ausgestaltungen der erfindungsgemäßen metallisierten Folien und deren Herstellungsverfahren sind gegenüber vorbekanntem eine Reduzierung der Produktionskosten um 20 % und sogar bis zu 50 %, die Verwendung vorhandener technischer Einrichtungen und bekannter Systeme, ökologische Vorteile und Herstellbarkeit in großen Mengen.

In den nachfolgenden Beispiele wird die Erfindung noch eingehender mit besonderen Anwendungsformen beschrieben.

### Beispiel 1

Für elektronische Bauteile, wie z.B. RF-Antennen, Flachantennen im Handy oder auch Leiterplatten sind in Abhängigkeit von der Anwendung höhere Leitfähigkeiten notwendig.

Für solche Bauteile sind Strukturen mit dickeren Cu-Schichten erforderlich, die dadurch erhalten werden, dass eine PET-Folie, die eine Stärke von 50 µm aufweist, vollflächig mit 0,5 µm Cu bedampft und anschließend im Tiefdruck "negativ" mit einem 2 µm bis 5 µm dicken Galvanoresist versehen wird. Danach wird die nicht bedruckte Cu-Oberfläche galvanisch mit Cu nachverstärkt. In weiteren Schritten wird der Galvanoresist gestrippt und das gewünschte Bauteil/Muster durch Differenzätzen fertiggestellt.

### Beispiel 2

Für Anwendungen, bei denen geringere Leitfähigkeiten benötigt werden, wie z.B. Leiterplatten, die Signalströme übertragen oder Antennen, im Bereich der Hochfrequenz von über 500 MHz arbeiten, sind z.T. dünnere Cu-Schichten ausreichend. Diese sind sehr kostengünstig über eine partiell Cu-metallisierte Folie herstellbar. Die Cu-Dicke beträgt vorzugsweise 0,1 µm bis 0,5 µm Cu und die verwendete PET-Folie ist vorzugsweise 36 µm bis 100 µm dick.

Für die Herstellung einer partiell bedampften Folie, die eine geringe Leitfähigkeit aufweisen soll, wird eine 50 µm dicke PET-Folie verwendet, auf die mit löslicher Farbe eine Struktur aufgedruckt wird. Die so bedruckte Folie wird mit Cu in einer Dicke von ca. 0,1 µm bis 0,5 µm unter gleichzeitiger Bekeimung bedampft. Anschließend wird die löslich Farbe samt dem darüber liegenden Cu gelöst. An den zuvor nicht mit löslicher Farbe bedruckten Bereichen verbleibt Cu samt Bekeimung auf der Folie.

### Beispiel 3

Strukturierten Mehrschichtensystemen, bei denen Cu-Dicken zwischen 0,5 µm und 3,0 µm benötigt werden, wobei die Dicke vorzugsweise näher bei 1,0 µm liegt, werden in Bereichen, in denen geringere Cu-Dicken als in Beispiel 1 gefordert werden, eingesetzt, z.B. Leiterplatten für Signalströme, Antennen für Höchfrequenzübertragung, Heizelemente und dergleichen.

Für die Herstellung eines strukturierten Mehrschichtensystems, das die gleiche Struktur in allen Ebenen aufweist, wird als Trägerfolie eine 50 µm dicke PET-Folie verwendet, auf die zunächst eine Metallschicht aus 0,2 µm Cu unter gleichzeitiger Bekeimung gedampft wird. Dieser Vorgang wird dann beispielsweise viermal wiederholt. Darauf wird ein Ätzresist gedruckt, anschließend geätzt und der Ätzresist gestrippt.

Im Vergleich zu der in Beispiel 2 beschriebenen metallisierten Folie können durch das oben beschriebene Herstellungsverfahren genauere Strukturen erzielt werden, was maßgeblich von der Art des Aufbringens des Ätzrestist abhängt. Dadurch ist es möglich feinststrukturierte Leiterplatten herzustellen.

### Beispiel 4

Mit strukturierten Mehrschichtensystemen, die Schichten aufweisen, die verschiedene Materialien in einer Ebene besitzen, ist es beispielsweise möglich, unterschiedliche Leitfähigkeiten oder optische Effekte in einer Ebene zu erzeugen, die bei Sicherheitsmerkmalen eine weitere (höhere) Sicherheitsstufe bedeuten. Eine weitere Einsatzmöglichkeit besteht für die Identifikationsantennen (Qualitätskontrolle im Automobilbau) oder RF-Antennen, die der Quellensicherung dienen. Hier kann durch das "gezielte Auffüllen mit einem dielektrischen Material" zwischen den Leiterbahnen der Antenne, die Antenne kapazitiv so eingestellt werden, dass man sich die Bestückung mit einem Kondensator oder eine aufwendigere Parallellage erspart.

Ein strukturiertes Mehrschichtsystem mit verschiedenen Materialien in einer Ebene besteht aus einer 100 µm dicken PET-Folie, auf die im Positivdruck eine lösliche Farbe gedruckt wird. Anschließend wird als Metallschicht unter gleichzeitiger Bekeimung 0,2 µm Cu gedampft und danach gewaschen. Auf diese Schicht wird im Negativdruck eine Lösliche Farbe (Waschfarbe) aufgetragen. Darauf wird eine Oxidschicht aus SiOₓ unter gleichzeitiger Bekeimung in einer Dicke von 0,2 µm gesputtert und anschließend die Lösliche Farbe (Waschfarbe) durch Waschen von den nicht mit Metall besetzten Stellen entfernt.

### Beispiel 5

Für Anwendungen, bei denen geringere Leitfähigkeiten benötigt werden, wie z.B. Leiterplatten, die Signalströme übertragen oder Antennen, im Bereich der Hochfrequenz von über 500 MHz arbeiten, sind z.T. dünnere Cu-Schichten ausreichend.

Für diesen Anwendungsbereich wird eine PET-Folie verwendet, die vorzugsweise 50 µm dick ist, und auf der eine aufgedampfte metallische Schicht ohne Vorbehandlung nicht haften würde.

In einem ersten Verfahrensschritt wird ein gut haftender Metallisierungsprimer in einer Dicke von ca. 1 µm bis 5 µm aufgedruckt(Struktur im Positivdruck). Die so bedruckte Folie wird mit Cu in einer Dicke von 0,1 µm bis 3 µm unter gleichzeitiger Bekeimung einfach bzw. mehrfach bedampft. Anschließend wird das Cu mechanisch von den nicht mit Primer bedruckten Bereichen der Folie entfernt.

Im Rahmen der Erfindung sind ferner Maßnahmen enthalten, um die Verankerung der Metallisierung (Musterschicht) auf dem Substrat sowie ggf. die Haftung deren metallischen Schichten (Musterschicht und Verstärkungsschicht) untereinander zu verbessern. Hierzu eignen sich besonders Cr, Al, Ag, Ti, Ni, Cu, TiOₓ, SiOₓ, CrOₓ.

Durch höhere Aufdampfraten und/oder galvanische Verstärkungen lassen sich die erreichbaren Dicken der metallischen Schicht(en), wie etwa Leiterbahnen, weiter erhöhen. Von Vorteil sind ferner Verbesserungen der partiellen Entfernung der Schicht; soweit diese erforderlich ist, und der gesamten Produktionsumgebung, wie z.B. eine Reinraumfertigung. Erforderlichenfalls können auch Produktionshilfsmittel, wie die diversen Resiste und Lacke, Primer, Lösliche Farbe (Waschfarbe), Leitlack optimiert werden. Das Aufbringen der Metallisierung der Musterschicht kann beispielsweise mittels bekannter Aufdampftechniken, einschließlich normale Verdampfertechniken und Mehrschichtaufdampfen, erfolgen. Für die Verankerungstechnologie der Metallisierung der Trägerfolie können Plasmarezepturen insbesondere hinsichtlich der Bekeimung und Aktivierung optimiert werden. Die Demetallisierung ermöglicht Variationen u.a. bei der Auswahl der Lösliche Farbe (Waschfarbe), Hochdruckeinheit, Waschtrommel, Strippereinheit, usw. Bei einer Anwendung von Tiefdruck lassen sich der Tiefdruckzylinder, Auftragswerk und die Lösliche Farbe (Waschfarbe) anpassen. Ätzresist und Ätzbad können erforderlichenfalls geeignet gewählt werden. Leitlacke können leitfähige Pigmente oder Polymere aufweisen.

## Patentansprüche

1. Verfahren zur Herstellung einer metallisierten Folie als Faden, Streifen oder Patch für Banknoten, Wertpapiere und Kreditkarten, als RF-Antenne für Transponder, Smart Cards, Smart Labels, Tags, als RF-Antenne in Diebstahletiketten, als Kontrolletiketten für die Qualitätssicherung, **dadurch gekennzeichnet, daß**
ein Substrat oder eine Trägerfolie im Vakuum mittels einer Plasmabehandlung gereinigt und gleichzeitig mit Targetatomen bekeimt wird,
anschließend das so vorbehandelte Substrat oder die vorbehandelte Trägerfolie entweder mit einem Metall, einer Metallverbindung oder einer Legierung bedampft wird und
die strukturierte Schicht **dadurch** erzeugt wird, daß das beschichtete Substrat oder die Folie positiv mit einem Ätzresist entsprechend dem gewünschten Muster bedruckt wird,
dann ein Ätzvorgang zum Entfernen der nicht mit dem Ätzresist bedruckten Stellen durchgeführt wird,
die strukturierte Schicht in der gewünschten Form und Dicke auf der Folie oder dem Substrat verbleibt und dann der Ätzresist gestrippt wird, und
die strukturierte Schicht durch chemischen, physikalischen oder galvanischen Materialauftrag unter Bildung einer Verstärkungsschicht nachverstärkt wird.

2. Verfahren zur Herstellung einer metallisierten Folie nach Anspruch 1,
**dadurch gekennzeichnet, daß**
auf dem vorgereinigten und bekeimten Substrat oder der vorgereinigten und bekeimten Trägerfolie 2 bis n strukturierte Schichten aufgebracht werden, wobei jede strukturierte Schicht unterschiedliche Materialien in der gleichen Schicht aufweisen kann, und
die Targetatome für die Bildung der einzelnen Bekeimungsschichten identisch oder verschieden sein können.

3. Verfahren nach Anspruch 2, **dadurch gekennzeichnet, daß**
zwei Strukturen aus unterschiedlichen Materialien in derselben Ebene der Schicht hergestellt werden können.

4. Verfahren nach einem der Ansprüche 1 bis 3, **dadurch gekennzeichnet, daß**
als Metalle Cu, Al, Fe, Ag, Cr, Ni, Zn, als Metallverbindungen TiO₂, CrOₓ, ZnS, ITO, FTO, ATO, ZnO, Al₂O₃, SiOₓ, als Legierungen Cu-Al, Cu-Zn, sowie als Isolatoren organische Substanzen eingesetzt werden.

5. Verfahren nach einem der Ansprüche 1 bis 4, **dadurch gekennzeichnet, daß**
die aufgedampfte metallische oder isolatorische Schicht eine Dicke von 0,01 µm bis 3,0 µm, vorzugsweise 0,1 µm bis 1,0 µm, besonders bevorzugt 0,2 µm bis 0,4 µm.

6. Verfahren nach einem der Ansprüche 1 bis 5, **dadurch gekennzeichnet, daß**
die Targetatome Metalle oder Metalloxide ausgewählt werden aus der Gruppe bestehend aus Cr, Al, Ag, Ti, Cu, Ni, SiOₓ, CrOx, TiOₓ.

7. Verfahren nach einem der Ansprüche 1 bis 6, **dadurch gekennzeichnet, daß**
die Targetatome in einer Dicke von 0,2 nm bis 50 nm aufgebracht werden.

8. Verfahren nach einem der Ansprüche 1 bis 7, **dadurch gekennzeichnet, daß**
die Trägerfolie aus der Gruppe bestehend aus PI, PPS, PEEK, PEK, PK, PEI, PSU, PESU, PAEK, LCP, TPU, PEN, PBT, PET (OPET, PETG, APET), PA (PA 6, PA 6.6, PA 4.6, PA 6/66, PA 12, PA 6.12), PC, COC, POM, ABS, PVC, PP, PE, PTFE, ETFE ausgewählt werden und eine Dicke von 6 µm bis 700 µm aufweisen.

9. Verfahren nach einem der Ansprüche 1 bis 8, **dadurch gekennzeichnet, daß**
die Trägerfolie eine Dicke von 6 µm bis 700 µm, vorzugsweise 12 µm bis 100 µm, insbesondere bevorzugt 15 µm bis 50 µm.

10. Verfahren nach einem der Ansprüche 1 bis 9, **dadurch gekennzeichnet, daß**
das Substrat aus der Gruppe bestehend aus Papier, Aluminum-Folie, Spinnvliese, Stapelfaservliese und SMS-Vliese, die aus folgenden Polymeren PP, PET, PA und PPS hergestellt wurden, sowie Viskosevliese, die alle eine Dicke von 20 g/m² bis 500 g/m² aufweisen, ausgewählt werden.

11. Verfahren nach einem der Ansprüche 1 bis 10, **dadurch gekennzeichnet, daß**
die strukturierte Schicht zusammen mit der Verstärkungsschicht eine Dicke von 1 µm bis 50 µm, vorzugsweise von 2 µm bis 35 µm, insbesondere bevorzugt von 3 µm bis 15 µm aufweist

## Claims

1. Process for the manufacture of film as threads, strips or patches for bank notes, securities and credit cards, RF antennas for transponders, smart cards, smart labels, tags, as RF antennas in anti-theft labels, as control labels for quality assurance, **characterised by** the fact that
A substrate or carrier film in the vacuum is cleaned using a plasma treatment and simultaneously is coated with target atoms,
The substrate treated in this way or the pre-treated carrier film is given a vapour coating either with a metal, a metallic compound or an alloy, and
The structured layer is created by printing the coated substrate or film positively with an etch resist corresponding to the desired pattern,
Then an etching process is performed to remove the parts not printed with the etch resist,
The structured layer in the desired form and thickness remains on the film or substrate and the etch resist is stripped, and
The structured layer is strengthened through chemical, physical or galvanic material application to form a reinforcing layer.

2. Process for the manufacture of a metallised film according to Claim 1, **characterised by** the fact that
2 to n structured layers are applied to the pre-cleaned and coated substrate or to the pre-cleaned and coated carrier foil, whereby each structured layer can have different materials in the same layer, and
The target atoms for forming the individual coating layers can be identical or different.

3. Process according to Claim 2, **characterised by** the fact that
Two structures made from different materials can be manufactured in the same level of the later.

4. Process according to Claims 1 to 3, **characterised by** the fact that
All metals Cu, Al, Fe, Ag, Cr, Ni, Zn are used as metallic compounds TiO₂, CrOₓ, ZnS, ITO, FTO, ATO, ZnO, Al₂O₃, SiOₓ, as alloys Cu-Al, Cu-Zn and organic substances as insulators.

5. Process according to one of the claims 1 to 4, **characterised by** the fact that
The vapour-coated metallic or insulating layer has a thickness of 0.01 µm to 3.0 µm, ideally 0.1 µm to 1.0 µm, particularly preferred: 0.2 µm to 0.4 µm.

6. Process according to one of the Claims 1 to 5, **characterised by** the fact that
The target atoms are selected from metals or metal oxides from the group comprise Cr, Al, Ag, Ti, Cu, Ni, SiOₓ, CrOₓ, TiOₓ.

7. Process according to Claims one of the 1 to 6, **characterised by** the fact that
The target atoms are applied in a thickness of 0.2 nm to 50 nm.

8. Process according to one of the Claims 1 to 7, **characterised by** the fact that
the carrier film is selected from the group comprising PI, PPS, PEEK, PEK, PK, PEI, PSU, PESU, PAEK, LCP, TPU, PEN, PBT, PET (OPET, PETG, APET), PA (PA 6, PA 6.6, PA 4.6, PA 6/66, PA 12, PA 6.12), PC, COC, POM, ABS, PVC, PP, PE, PTFE, ETFE and has a thickness of 6 µm to 700 µm.

9. Process according to one of the Claims 1 to 8, **characterised by** the fact that
The carrier film has a thickness of 6 µm to 700 µm, ideally 12 µm to 100 µm, particularly preferred: 15 µm to 50 µm

10. Process according to one of the Claims 1 to 9, **characterised by** the fact that
the substrate is selected from the group comprising paper, aluminium foil, spunbonded fabrics, staple-fibre fabrics and SMS fabrics which have been made from the following polymers, PP, PET, PA and PPS, and viscose fabrics, which all have a thickness of 20 g/m² to 500 g/m².

11. Process according to one of the Claims 1 to 10, **characterised by** the fact that
The structured layer together with the strengthening layer has a thickness of 1 µm to 50 µm, ideally 2 µm to 35 µm, particularly preferred: 3 µm to 15 µm.

## Revendications

1. Procédé de fabrication d'une feuille métallisée servant de fil, de bande ou de patch pour des billets de banque, des titres et des cartes de crédit, d'antenne RF pour des transpondeurs, des Smart Cards, des Smart Labels, des tags, d'antenne RF dans des étiquettes anti-vol, d'étiquettes de contrôle pour l'assurance qualité, **caractérisé en ce qu'**un substrat ou une feuille support est nettoyé(e) sous vide au moyen d'un traitement au plasma et en même temps ensemencé(e) avec des atomes cibles, que le substrat ainsi prétraité ou la feuille support ainsi prétraitée est revêtue d'un métal, d'une combinaison de métaux ou d'un alliage par évaporation, que la couche structurée est produite par le fait que le substrat revêtu ou la feuille revêtu(e) est imprimée positivement d'un masque de gravure selon le motif souhaité, qu'un processus de gravure a lieu ensuite pour éliminer les endroits non imprimés du masque de gravure, que la couche structurée demeure sur la feuille ou sur le substrat dans sa forme et dans son épaisseur souhaitées et que le masque de gravure est strippé et la couche structurée est renforcée grâce à un apport chimique, physique ou galvanique de matière qui forme une couche de renfort.

2. Procédé de fabrication d'une feuille métallisée suivant la revendication 1, **caractérisé en ce que** 2 à x couches structurées sont apportées sur le substrat ou sur la feuille support préalablement nettoyé(e) et ensemencé(e), chaque couche structurée pouvant présenter des matières différentes dans la même couche et les atomes cibles pour la formation des différentes couches d'ensemencement pouvant être identiques ou différentes.

3. Procédé suivant la revendication 2, **caractérisé en ce que** deux structures peuvent être fabriquées dans des matières différentes sur le même plan de la couche.

4. Procédé suivant une des revendications 1 à 3, **caractérisé en ce que** l'on utilise Cu, Al, Fe, Ag, Cr, Ni, Zn comme métaux, TiO₂, CrOₓ, ZnS, ITO, FTO, ATO, ZnO, Al₂O₃, SiOₓ comme combinaisons de métaux, Cu-Al, Cu-Zn comme alliages, ainsi des substances organiques comme isolateurs.

5. Procédé suivant une des revendications 1 à 4, **caractérisé en ce que** la couche métallique ou isolatrice appliquée par évaporation présente une épaisseur comprise entre 0,01 µm et 3,0 µm, de préférence entre 0,1 µm et 1,0 µm, épaisseur préférée en particulier de 0,2 µm à 0,4 µm.

6. Procédé suivant une des revendications 1 à 5, **caractérisé en ce que** les atomes cibles, métaux ou oxydes de métaux sont choisis parmi un groupe composé de Cr, Al, Ag, Ti, Cu, Ni, SiOₓ, CrOₓ, TiOₓ.

7. Procédé suivant une des revendications 1 à 6, **caractérisé en ce que** les atomes cibles appliqués forment une épaisseur comprise entre 0,2 nm et 50 nm.

8. Procédé suivant une des revendications 1 à 7, **caractérisé en ce que** la feuille support est choisie parmi un groupe composé de PI, PPS, PEEK, PEK, PK, PEI, PSU, PESU, PAEK, LCP, TPU, PEN, PBT, PET, (OPET, PETG, APET), PA (PA 6, PA 6.6, PA 4.6, PA 6/66, PA 12, PA 6.12), PC, COC, POM, ABS, PVC, PP, PE, PTFE, ETFE et présente une épaisseur comprise entre 6 µm et 700 µm.

9. Procédé suivant une des revendications 1 à 8, **caractérisé en ce que** la feuille support présente une épaisseur comprise entre 6 µm et 700 µm, de préférence entre 12 µm et 100 µm, épaisseur préférée en particulier de 15 µm à 50 µm.

10. Procédé suivant une des revendications 1 à 9, **caractérisé en ce que** le substrat est choisi parmi le groupe composé de papier, de feuille en aluminium, de non-tissé, de non-tissé en fibre artificielle discontinue et de non-tissé SMS, fabriqués à base des polymères suivants PP, PET, PA et PPS, ainsi que des non-tissés en viscose, qui présentent tous une épaisseur comprise entre 20g/m² et 500 g/m².

11. Procédé suivant une des revendications 1 à 10, **caractérisé en ce que** la couche structurée présente avec la couche de renfort une épaisseur comprise entre 1 µm et 50 µm, de préférence entre 2 µm et 35 µm, épaisseur préférée en particulier de 3 µm à 15 µm.
